# EUROPÄISCHE PATENTANMELDUNG

(11) **EP 3 667 344 A1**
(43) Veröffentlichungstag der Anmeldung: **17.06.2020**
(21) Anmeldenummer: 19209958.8
(22) Anmeldetag: 19.11.2019
(51) Int. Cl.: G01R 31/385, G01N 27/48

(54) **VORRICHTUNG ZUR ELEKTROCHEMISCHEN BESTIMMUNG DER MENGE VON INSBESONDERE FLÜSSIGEN BESTANDTEILEN IN KOMPONENTEN FÜR BATTERIEZELLEN, VERFAHREN ZUM BETRIEB DERSELBEN SOWIE DEREN VERWENDUNG**

(30) Priorität: 12.12.2018 DE 102018221456
(71) Anmelder: Robert Bosch GmbH, 70442 Stuttgart (DE)
(72) Erfinder: Berner, Ulrich, 70176 Stuttgart (DE); Gallagher, Kevin Gregory, 85221 Dachau (DE)

(57) **Zusammenfassung**

Es wird Vorrichtung zur Bestimmung der Menge von insbesondere flüssigen Bestandteilen in Komponenten für Batteriezellen in Form einer Elektrode, eines Separators oder einer Kombination derselben, umfassend eine Aufnahmevorrichtung (14) zur Aufnahme einer untersuchenden Komponente (100) für Batteriezellen beschrieben, wobei die Vorrichtung (10, 20, 30, 40, 50) mindestens zwei elektrische Kontakte (16) aufweist, die insbesondere reversibel mit der zu untersuchenden Komponente (100) für Batteriezellen in physischen Kontakt bringbar ausgeführt sind, wobei ein Mittel (18) zum Anlegen einer Spannung an die elektrischen Kontakte (16) vorgesehen ist, wobei weiterhin eine Vorrichtung (42) zur Bestimmung eines bei Anlegen der Spannung an die elektrischen Kontakte (16) fließenden elektrischen Stroms vorgesehen ist und wobei ein Mittel (19) zur Korrelation des durch die Komponente (100) fließenden elektrischen Stroms mit einer Menge von insbesondere flüssigen Bestandteilen in der Komponente (100) vorgesehen ist.

## Beschreibung

Die vorliegende Erfindung bezieht sich auf eine Vorrichtung zur Bestimmung der Menge von insbesondere flüssigen Bestandteilen in Komponenten für Batteriezellen sowie auf ein Verfahren zum Betrieb derselben und deren Verwendung gemäß dem Oberbegriff der unabhängigen Patentansprüche.

### Stand der Technik

Zur Speicherung elektrischer Energie werden üblicherweise Batterien eingesetzt. Bei diesen unterscheidet man sogenannte Primärbatterien, die nur einmal geladen werden können und sogenannte Sekundärbatterien, die mehrfach aufladbar sind. Üblicherweise umfassen derartige Batterien eine Mehrzahl einzelner Batteriezellen. Im Bereich sekundärer Batteriezellen, auch Akkumulatoren genannt, finden insbesondere sogenannte Lithium-Ionen-Batteriezellen Verwendung. Diese zeichnen sich u. a. durch eine hohe Energiedichte, eine gute thermische Stabilität sowie eine äußerst geringe Selbstentladung aus. Akkumulatoren auf der Basis von Lithium-Ionen-Batteriezellen finden somit u. a. Anwendung in Kraftfahrzeugen wie insbesondere Elektrofahrzeugen (electric vehicles, EV), in Hybridfahrzeugen (hybrid electric vehicles, HEV) sowie in Plug-In-Hybridfahrzeugen (plug-in-hybrid-electric vehicles, PHEV).

Lithium-Ionen-Batteriezellen umfassen jeweils eine Kathode als positive Elektrode sowie eine Anode als negative Elektrode. Beide Elektroden umfassen jeweils einen metallischen Stromableiter, auf dem ein elektrochemisches Aktivmaterial aufgebracht ist, an dessen Oberfläche die der elektrischen Stromspeicherung zugrundeliegenden elektrochemischen Prozesse ablaufen. So werden für Kathoden üblicherweise als Aktivmaterialien Metalloxide eingesetzt. Als Aktivmaterial für Anoden werden heute üblicherweise kohlenstoffhaltige Aktivmaterialien wie Graphit oder amorpher Kohlenstoff (hard carbon) eingesetzt oder auch Silizium oder Lithiumtitanate.

Neuere Entwicklungen zielen auf die Verwendung von metallischem Lithium als Aktivmaterial der Anode. Als Separator derartiger lithiummetallhaltiger Batteriezellen werden insbesondere feste Elektrolytmaterialien eingesetzt. Diese unterstützen beispielsweise beim Laden der Batteriezelle eine flächig ebene Abscheidung metallischen Lithiums im Bereich der Anode und verhindern, dass Lithium in Form von Dendriten aufwächst. Dafür werden überwiegend steife, insbesondere polymere Festelektrolyte mit einer Submikro- oder Nanostruktur eingesetzt. Diese sind auch bei Betriebstemperaturen einer derartigen Batteriezelle im Bereich von ca. 80°C in der Lage, eine entsprechende mechanische Stabilisierung der aus Lithiummetall gebildeten Anode zu leisten.

Typische verwendete Polymerelektrolyte, beispielsweise auf Polyethylenoxid-Basis (PEO) sind bei Temperaturen oberhalb dieser typischen Betriebstemperaturen flüssig. Ab 180°C ist Lithium in metallischer Form jedoch selbst flüssig und ein in diesem Bereich ebenfalls flüssiger Separator kann dann den Kontakt zwischen dem verwendeten Lithium und einer Kathode der Batteriezelle nicht verhindern. Dies würde zu sicherheitskritischen Zuständen in der Batteriezelle führen.

Derartige Festelektrolytzellen können organische Lösungsmittel und Restmengen an Wasser enthalten.Dies kann zu unerwünschten Nebenreaktionen vor allem an lithiumhaltigen Anoden führen. Dabei können sich bspw. resistive Schichten und/oder Gase bilden, die den Schichtverbund der Festelektrolytzelle beeinträchtigen können. Voraussetzung ist daher, dass derartige Lösungsmittel nach dem Herstellen der entsprechenden Komponenten für Batteriezellen ausreichend sorgfältig entfernt werden, da lithiumbasierte Batteriezellen normalerweise Materialien mit sehr geringen Mengen an Verunreinigungen (Battery-grade) erfordern.

Hauptgrund dafür ist, dass Verunreinigungen je nach elektrochemischer Stabilität an den Elektroden abreagieren, z. B. an der Anode reduziert oder an der Kathode oxidiert werden. Dies kann zu festen Reaktionsprodukten an einer Grenzschicht der Elektrode (Solid-Elektrolyt-Interface) oder zu mobilen Spezies im Elektrolyten führen. Beides führt normalerweise zu nachteiligen Batterieeigenschaften.

Besonders anspruchsvoll sind Batterien mit metallischem Lithium als Anode, welches das geringste elektrochemische Potential aller bekannten Substanzen hat (-3,04V versus SHE). Polymerbatterien erfordern jedoch üblicherweise organische Lösungsmittel zur Herstellung der Elektroden oder Separatoren. Diese Lösungsmittel müssen nach der Herstellung möglichst vollständig entfernt werden, um zu verhindern, dass diese an den Elektroden abreagieren.

Es daher wichtig zu wissen, wie hoch der Restgehalt an Lösungsmittel in der Elektrode einer entsprechenden Batteriezelle ist. Für viele Lösungsmittel gibt es bisher jedoch kein geeignetes Verfahren, um deren Gehalt in einem festen Elektrolyten zu bestimmen.

Batterien mit auf polymeren Festelektrolyten basierenden Batteriezellen sind weiterhin extrem empfindlich gegenüber einer Restfeuchte. Diese kann sich negativ auf nahezu alle Batterieparameter auswirken. Daher ist eine Kenntnis über den Wassergehalt z.B. einer Batteriekathode während der Herstellung von hoher Bedeutung.

Aus der US 2016/344080 ist diesbezüglich eine Metall-Luft-Batterie bekannt, bei der die der Batterie zugeführte Luft vor dem Eintritt über eine Reinigungseinheit gereinigt wird. Die Reinigung erfolgt durch die Absorption von Verunreinigungen. Auf diese Weise kann beispielsweise Wasser aus der zugeführten Luft entfernt werden.

Die Messung des Wassergehalts in Polymerbatterien ist alles andere als trivial. Als bevorzugte Methode werden heute Karl Fischer Titrationen durchgeführt. Diese Methode hat allerdings mehrere Nachteile, darunter sind die aufwändige Probenpräparation, das zeitintensive Bestimmungsverfahren, die Notwendigkeit einer Blindwertmessung und die Sensitivität gegenüber vielen anderen Verunreinigungen zu nennen.

Diesbezüglich ist weiterhin aus der US 2012/106017 eine Überwachungsvorrichtung einer Kraftfahrzeugbatterie bekannt, die beispielsweise den Wassergehalt innerhalb der Batterie bestimmt. Auf diese Weise können sicherheitskritische Zustände vermieden werden.

### Offenbarung der Erfindung

Erfindungsgemäß wird eine Vorrichtung zur Bestimmung der Menge von insbesondere flüssigen Bestandteilen in Komponenten für Batteriezellen sowie ein Verfahren zum Betrieb derselben und deren Verwendung mit den kennzeichnenden Merkmalen der unabhängigen Patentansprüche zur Verfügung gestellt.

Die erfindungsgemäße Vorrichtung zur Bestimmung der Menge von insbesondere flüssigen Bestandteilen in Komponenten für Batteriezellen dient beispielsweise der Bestimmung Wasser oder von organischen Lösungsmitteln wie bspw. Ketonen wie Cyclohexanon oder Ethern wie Tetrahydrofuran oder N-Methylpyrrolidon in Komponenten für Batteriezellen.

Bei den Komponenten für Batteriezellen handelt es sich beispielsweise um eine Anode oder eine Kathode der Batteriezelle oder um einen Separator der Batteriezelle. Weiterhin kann es sich bei der Komponente für Batteriezellen um eine Kombination einer oder zweier Elektroden mit einem Separator handeln.

Die erfindungsgemäße Vorrichtung zur Bestimmung der Menge von insbesondere flüssigen Bestandteilen in Komponenten für Batteriezellen umfasst beispielsweise eine Aufnahme für eine zu untersuchende Komponente für Batteriezellen. Darin wird die zu untersuchende Komponente für Batteriezellen reversibel aufgenommen.

Erfindungsgemäß ist nun vorgesehen, dass die Vorrichtung zur Bestimmung der Menge von insbesondere flüssigen Bestandteilen in Komponenten für Batteriezellen weiterhin zwei flächige elektrische Kontakte oder Kontaktierungsmittel aufweist, die reversibel mit der zu untersuchenden Komponente für Batteriezellen in physischen Kontakt bringbar ausgeführt sind.

Weiterhin ist von Vorteil, wenn die auf die flächigen elektirschen Kontakte oder Kontaktierungsmittel wirkende oder von diesen bewirkte Klemmkraft entweder gemessen bzw. geregelt wird oder anderweitig bei jeder Messung identisch gehalten wird.

Weiterhin ist vorgesehen, dass die Vorrichtung zur Bestimmung der Menge von insbesondere flüssigen Bestandteilen in Komponenten für Batteriezellen ein Mittel zum Anlegen einer Spannung an die elektrischen Kontakte bzw. Kontaktierungmittel umfasst, dass eine Vorrichtung zur Bestimmung eines bei Anlegen der Spannung an die elektrischen Kontakte fließenden elektrischen Stroms vorgesehen ist und dass ein Mittel zur Korrelation des durch die Komponente fließenden elektrischen Stroms mit einer Menge von insbesondere flüssigen Bestandteilen in der Komponente vorgesehen ist.

Diese Vorgehensweise hat den Vorteil, dass Komponenten für Batteriezellen bereits in einem nicht verbauten Zustand hinsichtlich überwiegend unerwünschter flüssiger Bestandteile untersucht werden können. Deren Gehalt im Material von Elektroden oder Separatoren kann auf einfache Weise und gleichzeitig sehr exakt auf elektrochemischem Wege bestimmt werden.

Weitere vorteilhafte Ausführungsformen der vorliegenden Erfindung sind Gegenstand der Unteransprüche.

So ist es von Vorteil, wenn für die Bestimmung der Menge von insbesondere flüssigen Bestandteilen in einer Komponente für Batteriezellen in Form eines Schichtverbundes einer Elektrode mit einem Separator ein erster und ein zweiter elektrischer Kontakt vorgesehen ist, wobei der zweite elektrische Kontakt als ein Kontaktierungsmittel zur reversiblen elektrischen Kontaktierung der Elektrode ausgebildet ist, beispielsweise indem ein Stromableiter der Elektrode kontaktiert wird, derart, dass das Anlegen der Spannung zwischen dem ersten elektrischen Kontakt und dem Kontaktierungsmittel erfolgt.

Auf diese Weise kann auch eine Komponente für Batteriezellen untersucht werden, die einen Schichtverbund aus einer oder mehrerer Elektroden, insbesondere Kathoden mit einem Separator umfasst.

Gemäß einer weiteren vorteilhaften Ausführungsform der vorliegenden Erfindung umfasst die Vorrichtung zur Bestimmung der Menge von insbesondere flüssigen Bestandteilen in Komponenten für Batteriezellen ein Steuerungsmittel zum Anlegen einer Spannung oder eines Spannungsverlaufs an die Komponente für Batteriezellen. Dabei umfasst das Steuerungsmittel einen Speicher und/oder ein gespeichertes Kennfeld, in dem eine entsprechende Spannung oder ein entsprechender Spannungsverlauf hinterlegt ist, bei dessen Anwendung es zu einem besonders vorteilhaften bzw. genauen Ergebnis der Bestimmung kommt. Insbesondere ist ein gespeichertes Kennfeld vorgesehen, das eine elektrische Spannung oder einen Spannungsverlauf in Abhängigkeit eines in der Komponente für Batteriezellen enthaltenen insbesondere flüssigen Bestandteils zeigt.

Gemäß einer weiteren vorteilhaften Ausführungsform der Erfindung umfasst der mindestens eine elektrische Kontakt eine Heizvorrichtung, insbesondere eine elektrische Widerstandsheizung. Der Vorteil dieser Ausführungsform besteht darin, dass eine Untersuchung von Komponenten für Batteriezellen auch bei höheren Temperaturen durchgeführt werden kann, was je nach Material von Elektroden- oder Separatorschichten der Komponente zu genaueren Messergebnissen führt.

Darüber hinaus ist es von Vorteil, wenn ein Flächeninhalt der Fläche des elektrischen Kontakts, die mit der zu untersuchenden Komponente für Batteriezellen in physischen Kontakt kommt, kleiner ist als der Flächeninhalt einer Großfläche der zu untersuchenden Komponente. Auf diese Weise können Kurzschlüsse, bei denen ein Stromfluss zwischen den elektrischen Kontakten der Vorrichtung zur Bestimmung der Menge von insbesondere flüssigen Bestandteilen in Komponenten für Batteriezellen unter Auslassung der zu untersuchenden Komponente erfolgt, vermieden werden.

Weiterhin ist auch ein Verfahren zum Betrieb einer Vorrichtung zur Bestimmung der Menge von insbesondere flüssigen Bestandteilen in Komponenten für Batteriezellen Gegenstand der Erfindung, bei dem in einem ersten Schritt eine Komponente für Batteriezellen von einer Aufnahmevorrichtung der Vorrichtung aufgenommen wird, in einem zweiten Schritt mindestens zwei elektrische Kontakte bzw. Kontaktierungsmittel mit der Komponente für Batteriezellen in physischen Kontakt gebracht werden, in einem dritten Schritt an die Komponente für Batteriezellen eine elektrische Spannung mittels der mindestens zwei elektrischen Kontakte angelegt wird und der sich aufgrund der angelegten Spannung einstellende elektrische Strom erfasst und mit der Menge eines Bestandteils in der Komponente korreliert wird.

Dabei ist es besonders vorteilhaft, wenn die Korrelation eines sich in Abhängigkeit der angelegten Spannung einstellenden Stroms mit der Menge eines Bestandteils in der Komponente erfolgt, indem einer Ladungsmenge des sich einstellenden Stroms oder einem Integral der Stromstärke über der Zeit eine Menge eines oder mehrerer insbesondere flüssiger Bestandteile in der Komponente für Batteriezellen zugeordnet wird, da ein sich in der Komponente einstellender Zersetzungsstrom aufgrund einer elektrochemischen Oxidation bzw. Reduktion eines zu bestimmenden Anteils ein direktes Äquivalent zu der Menge des Bestandteils in der Komponente für Batteriezellen bildet.

Weiterhin ist von Vorteil, wenn bei der Korrelation darüber hinaus ein Flächeninhalt der Fläche des elektrischen Kontakts bzw. Kontaktmittels, die mit der zu untersuchenden Komponente in physischen Kontakt kommt, mit berücksichtigt wird.

Gemäß einer weiteren besonders vorteilhaften Ausführungsform wird zur Bestimmung der Menge von organischen Bestandteilen, insbesondere von Cyclohexanon in Komponenten für Batteriezellen, als Komponente für Batteriezellen ein Schichtverbund zweier Elektroden gleichen Materials mit mindestens einem Separator verwendet. Der besondere Vorteil besteht darin, dass die Menge eines zu bestimmenden Bestandteils bei Verwendung zweier Elektroden gleichen Materials im Material derselben in etwa doppelt so hoch sein wird und bei der Bestimmung dieser Menge durch simultane Untersuchung zweier Elektroden ein genauerer Messwert erhalten wird.

Die erfindungsgemäße Vorrichtung bzw. das Verfahren zu dessen Betrieb lässt sich vorteilhaft verwenden bei der Herstellung von Batteriezellen, insbesondere lithiumhaltigen, wiederaufladbaren Batteriezellen für Batterien, die Anwendung finden in mobilen Anwendungen wie Elektrofahrzeugen, Hybridfahrzeugen oder Plug-In-Hybridfahrzeugen sowie in portablen Anwendungen wie beispielsweise Heimwerkergeräten oder in Einrichtungen zur mobilen Telekommunikation, aber auch Anwendung finden in stationären Energiespeichern beispielsweise zur Speicherung regenerativ gewonnener elektrischer Energie oder in Brennstoffzellen.

### Kurze Beschreibung der Zeichnungen

Ausführungsformen der vorliegenden Erfindung sind in der Zeichnung dargestellt und in der nachfolgenden Figurenbeschreibung näher erläutert. Es zeigt
- Figur 1:: einen schematischen Ausschnitt einer Vorrichtung zur Bestimmung der Menge von insbesondere flüssigen Bestandteilen in Komponenten für Batteriezellen gemäß einer ersten Ausführungsform der vorliegenden Erfindung,
- Figur 2:: einen schematischen Ausschnitt einer Vorrichtung zur Bestimmung der Menge von insbesondere flüssigen Bestandteilen in Komponenten für Batteriezellen gemäß einer zweiten Ausführungsform der vorliegenden Erfindung,
- Figur 3:: einen schematischen Ausschnitt einer Vorrichtung zur Bestimmung der Menge von insbesondere flüssigen Bestandteilen in Komponenten für Batteriezellen gemäß einer dritten Ausführungsform der vorliegenden Erfindung,
- Figur 4a:: einen schematischen Ausschnitt einer Vorrichtung zur Bestimmung der Menge von insbesondere flüssigen Bestandteilen in Komponenten für Batteriezellen gemäß einer vierten Ausführungsform,
- Figur 4b:: die in Figur 4a dargestellte Vorrichtung in einem betriebsbereiten Zustand,
- Figur 5a:: einen schematischen Ausschnitt einer Vorrichtung zur Bestimmung der Menge von insbesondere flüssigen Bestandteilen in Komponenten für Batteriezellen gemäß einer fünften Ausführungsform der vorliegenden Erfindung,
- Figur 5b:: einen schematischen Ausschnitt der Vorrichtung gemäß Figur 5a zur Bestimmung der Menge von insbesondere flüssigen Bestandteilen in einer alternativen Komponente für Batteriezellen,
- Figur 5c:: einen schematischen Ausschnitt der Vorrichtung gemäß den Figuren 5a, 5b zur Bestimmung der Menge von insbesondere flüssigen Bestandteilen in einer weiteren alternativen Komponente für Batteriezellen,
- Figur 6:: ein schematisches Fließschaubild eines Verfahrens zum Betrieb der in den Figuren 1 bis 5 gezeigten Ausführungsformen der erfindungsgemäßen Vorrichtung und
- Figur 7:: eine schematische Darstellung eines Messprotokolls bei Durchführung des in Figur 6 dargestellten Verfahrens.

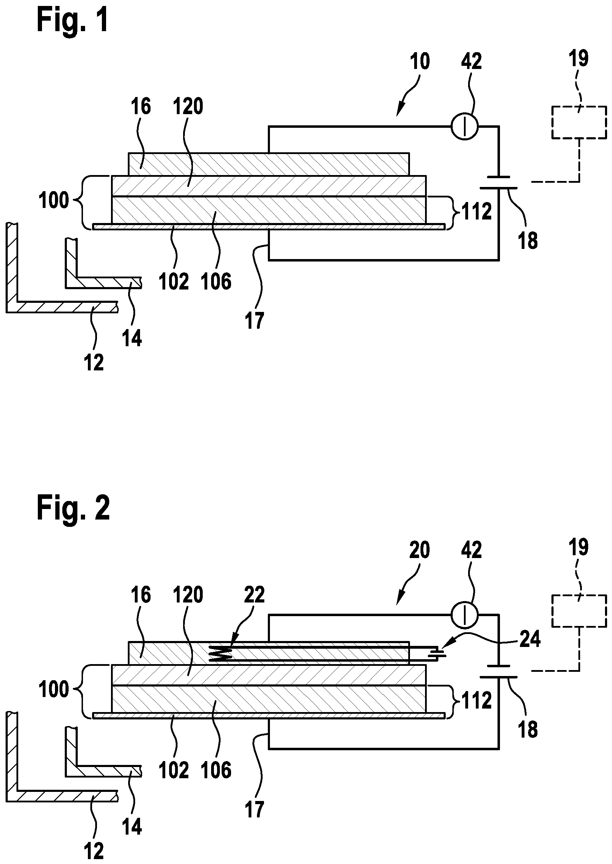

In Figur 1 ist eine Vorrichtung 10 zur Bestimmung der Menge von insbesondere flüssigen Bestandteilen in Komponenten für Batteriezellen gemäß einer ersten Ausführungsform der vorliegenden Erfindung dargestellt. Die Vorrichtung 10 umfasst ein in Figur 1 schematisch dargestelltes Gehäuse 12, in dem eine Aufnahmevorrichtung 14 positioniert ist, die der Aufnahme einer zu bestimmenden Komponente für Batteriezellen hinsichtlich einer Menge von insbesondere flüssigen Bestandteilen dient. Die Komponente 100 für Batteriezellen umfasst in Figur 1 beispielsweise eine Kathode 112, welche auf einer Großfläche mit einem Separator 120 bzw. einem Elektrolyten oder einer elektrolythaltigen Schicht versehen ist. Die Kathode 112 umfasst dabei bspw. ein zweites Elektrodenaktivmaterial 106 sowie einen Stromableiter 102. Weiterhin ist ein metallischer Kontakt 16 reversibel in physischem Kontakt mit dem Separator 120 positioniert.

Zur Bestimmung der Menge von insbesondere flüssigen Bestandteilen in der Komponente 100 werden der Stromableiter 102 der Komponente 100 über ein elektrisches Kontaktierungsmittel 17 sowie der metallische Kontakt 16 mit einer Spannungsquelle 18 elektrisch leitend verbunden. Durch Anlegen einer geeigneten Spannung durch die Spannungsquelle 18 an den elektrischen Stromableiter 102 und den metallischen Kontakt 16 kommt es zu elektrochemischen Vorgängen innerhalb der Komponente 100.

Dazu wird die an der Spannungsquelle 18 anliegende Spannung so eingestellt, dass es einerseits nicht zu einer elektrochemischen Veränderung des Materials des Separators 120 oder des Elektrodenaktivmaterials 106 der Kathode 112 kommt, andererseits die angelegte Spannung jedoch ausreichend hoch ist, um beispielsweise Lösungsmittelrückstände in dem Separator 120 oder der Kathode 112 elektrochemisch zu zersetzen, indem diese Lösungsmittelrückstände elektrochemisch reduziert bzw. oxidiert werden, und auf diese Weise eine Bestimmung ihrer Menge zu ermöglichen. Zur Bestimmung eines sich bei Anlegen der elektrischen Spannung einstellenden elektrischen Stroms ist weiterhin ein in den Stromkreis integriertes elektrisches Strommessgerät 42 vorgesehen.

Zur Steuerung der von der Spannungsquelle 18 bereitgestellten Spannung ist beispielsweise ein Steuerungsmittel 19 vorgesehen, in dem beispielsweise geeignete Spannungswerte beispielsweise in einem Speicher oder einem Kennfeld hinterlegt sind. Die geeigneten Spannungswerte können beispielsweise in Form eines Kennfeldes hinterlegt sein, bei dem eine an der Spannungsquelle 18 anliegende Spannung mit einem geeigneten Potentialverlauf zeitlicher Art korreliert ist oder mit der Art eines zu bestimmenden Lösungsmittels. Auf diese Weise kann zum einen je nach Wahl der an der Spannungsquelle 18 anliegenden Spannung eine zeitliche Änderung derselben beispielsweise in Form eines linearen Anstiegs der an der Spannungsquelle 18 anliegenden Spannung realisiert werden oder die an der Spannungsquelle 18 anliegende Spannung kann spezifisch für ein bestimmtes zu bestimmendes Lösungsmittel eingestellt werden. Die Art des zu bestimmenden Lösungsmittels kann beispielsweise über eine nicht dargestellte Bedieneinheit der Vorrichtung 10 dem Steuerungsmittel 19 mitgeteilt werden.

In Figur 2 ist eine Vorrichtung 20 zur Bestimmung der Menge von insbesondere flüssigen Bestandteilen in Komponenten für Batteriezellen in einer zweiten Ausführungsform dargestellt. Es bezeichnen gleiche Bezugszeichen gleiche Bauteilkomponenten wie in Figur 1.

Die Vorrichtung 20 ist so ausgeführt, dass der metallische Kontakt temperierbar, insbesondere erwärmbar ausgeführt ist. Dazu umfasst der metallische Kontakt 16 bspw. ein Heizelement 22, das bspw. als elektrisches Widerstandsheizelement ausgeführt ist. Das Heizelement 22 umfasst dazu bspw. eine Spannungsversorgung 24.

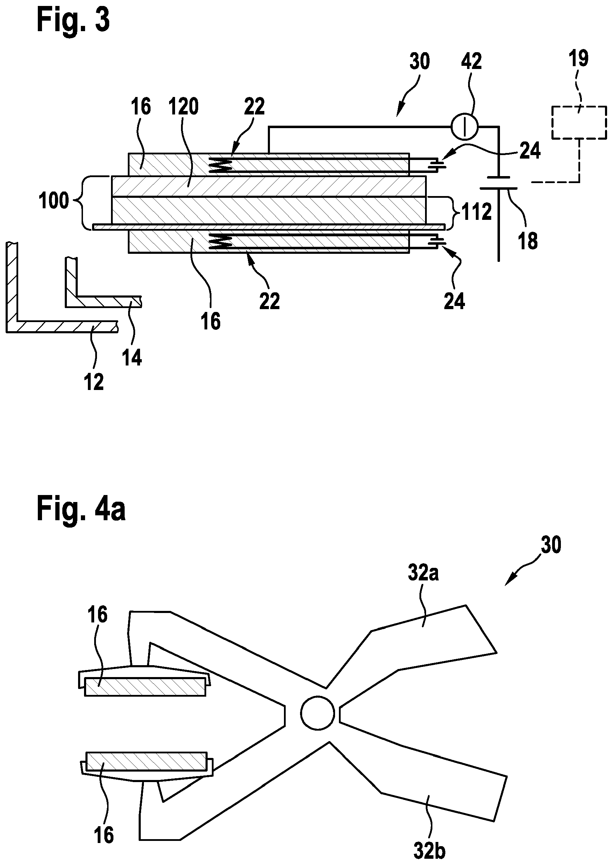

In Figur 3 ist eine Vorrichtung 30 zur Bestimmung der Menge von insbesondere flüssigen Bestandteilen in Komponenten für Batteriezellen in einer dritten Ausführungsform dargestellt. Es bezeichnen gleiche Bezugszeichen gleiche Bauteilkomponenten wie in den Figuren 1 und 2.

Die Vorrichtung 30 ist so ausgeführt, dass zwei metallische Kontakte 16 vorgesehen sind. Dabei ist mindestens einer, vorzugsweise aber sind beide metallische Kontakte 16 temperierbar, insbesondere erwärmbar ausgeführt. Dazu umfasst jeder temperierbare metallische Kontakt 16 bspw. ein Heizelement 22, das bspw. als elektrisches Widerstandsheizelement ausgeführt ist. Jedes Heizelement 22 umfasst dazu bspw. eine eigene Spannungsversorgung 24.

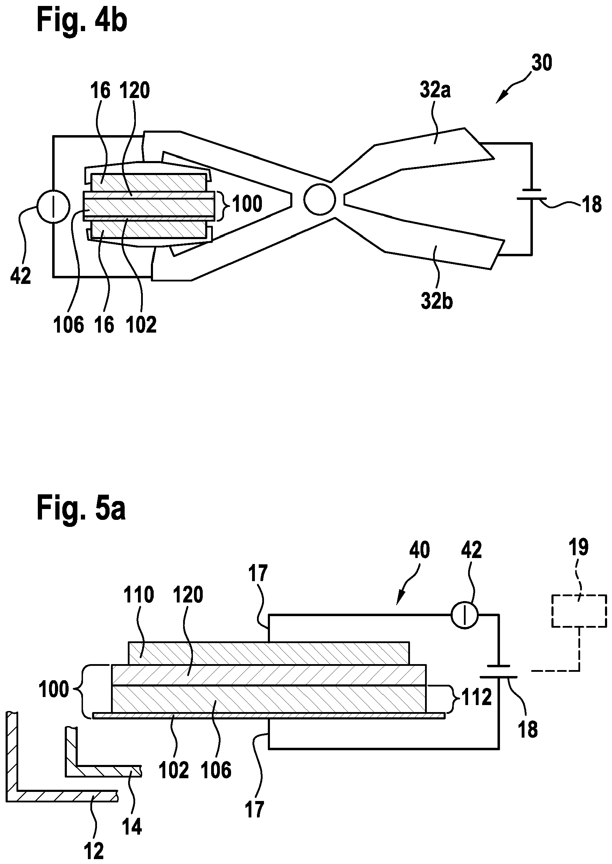

In den Figuren 4a und 4b ist eine Vorrichtung 30 zur Bestimmung der Menge von insbesondere flüssigen Bestandteilen in Komponenten für Batteriezellen in einer vierten Ausführungsform dargestellt. Es bezeichnen weiterhin gleiche Bezugszeichen gleiche Bauteilkomponenten wie in den Figuren 1 bis 3.

Dabei ist die Vorrichtung 30 in Form einer Klemmzwinge ausgeführt, die bspw. federbelastet ausgeführt ist, sodass eine zu untersuchende Komponente für Batteriezellen durch Klemmbacken der Klemmzwinge in einer zur Untersuchung geeigneten Position gehalten wird. Figur 4a zeigt die Vorrichtung 30 zur Bestimmung der Menge von insbesondere flüssigen Bestandteilen in Komponenten für Batteriezellen dabei in einer geöffneten Position und Figur 4b zeigt die Vorrichtung 30 in einer geschlossenen, eine zu untersuchende Komponente 100 umfassende Position.

Die Vorrichtung 30 gemäß vierter Ausführungsform ist so ausgeführt, dass zwei metallische Kontakte 16 vorgesehen sind, wobei mindestens einer, vorzugsweise aber beide metallische Kontakte 16 temperierbar, insbesondere erwärmbar ausgeführt sind.

Weiterhin weist die als Klemmzwinge ausgeführte Vorrichtung 30 bspw. zwei Griffvorrichtungen 32a, 32b auf, die bei einem Zusammendrücken der Griffvorrichtungen 32a, 32b, die einer translatorischen Bewegung der beiden Griffvorrichtungen 32a, 32b aufeinander zu entspricht, zu einer Bewegung der beiden metallischen Kontakte 16 voneinander weg führt, sodass eine zu untersuchende Komponente 100 in den sich zwischen den metallischen Kontakten 16 bildenden Raum eingebracht werden kann.

Da die als Klemmzwinge ausgebildete Vorrichtung 30 gemäß vierter Ausführungsform federbelastet ausgeführt ist, führt eine Rückstellkraft einer nicht dargestellten Feder dazu, dass bei einem Nachlassen einer auf die Griffvorrichtungen 32a, 32b ausgeübten Kraft die zu untersuchende Komponente 100 kraftschlüssig zwischen den beiden metallischen Kontakten 16 gehalten wird und in einen ausreichend guten elektrischen Kontakt mit den metallischen Kontakten 16 gebracht wird. Vorzugsweise wird die eingestellte Rückstellkraft variiiert und definiert eingestellt, um gleichbleibende Bedingungen zu garantieren.

Vorzugsweise sind die beiden Griffvorrichtungen 32a, 32b elektrisch isoliert voneinander ausgeführt. Die Spannungsquelle 18 ist derart positioniert, dass eine elektrische Spannung an die Griffvorrichtungen 32a, 32b angelegt werden kann. Zur Bestimmung eines sich bei Anlegen einer elektrischen Spannung einstellenden elektrischen Stroms, sind die Griffvorrichtungen 32a, 32b weiterhin mit dem elektrischen Strommessgerät 42 in elektrisch leitender Verbindung stehend ausgeführt.

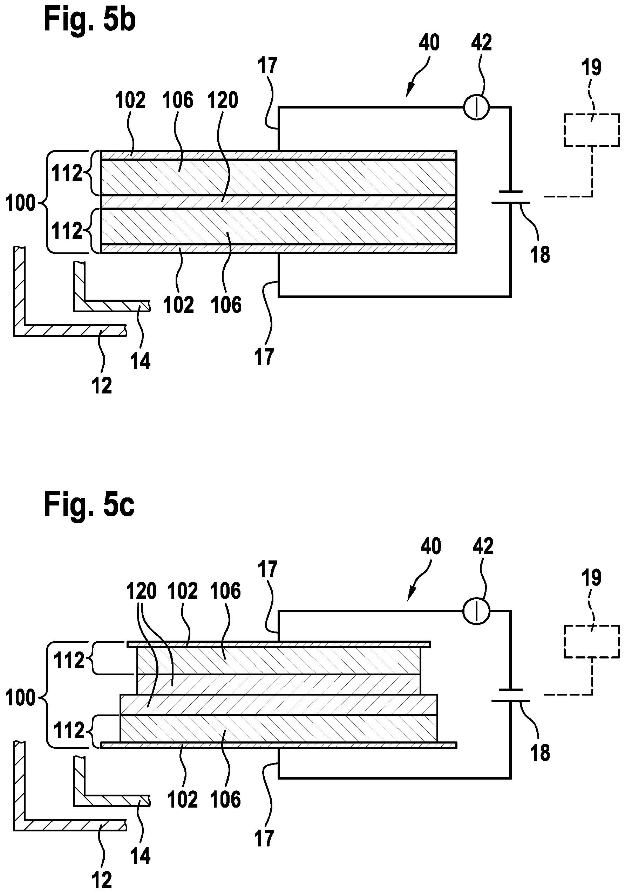

In den Figuren 5a, 5b und 5c ist eine Vorrichtung 40 zur Bestimmung der Menge von insbesondere flüssigen Bestandteilen in Komponenten für Batteriezellen in einer vierten Ausführungsform dargestellt. Es bezeichnen gleiche Bezugszeichen gleiche Bauteilkomponenten wie in den vorhergehenden Figuren.

Die in den Figuren 5a bis 5b dargestellte Vorrichtung 40 ist unter Verzicht auf einen elektrischen Kontakt mit zwei Kontaktierungsmitteln 17 ausgestattet, die einen reversiblen elektrischen Kontakt mit einer zu untersuchenden Komponente für Batteriezellen 100 gestattet. Die Vorrichtung 40 gemäß vierter Ausführungsform ist insbesondere zur Untersuchung von Komponenten 100 für Batteriezellen geeignet, die auf ihren Großflächen bereits selbst eine elektrisch leitfähige Beschichtung aufweisen, die lediglich einer elektrischen Kontaktierung mittels eines Kontaktierungsmittels 17 mit verhältnismäßig geringer Querschnittsfläche bzw. über eine Steckkontakt bedarf. Daher kann auf das Vorsehen von metallischen Kontakten, die eine flächige Kontaktierung von Oberflächenbereichen der Komponente 100 erlauben, verzichtet werden.

Als zu untersuchende Komponente 100 eignet sich bspw., wie in Figur 5a dargestellt, eine Elektrodenanordnung, umfassend eine Kathode 112 mit einem zweiten Elektrodenaktivmaterial 106 sowie einem Stromableiter 102, wobei die Kathode 112 auf einer Großfläche mit einem Separator 120 bzw. einem Elektrolyten oder einer elektrolythaltigen Schicht versehen ist. Auf dessen gegenüberliegender Großfläche ist bspw. eine Anode 110 in Form einer Schicht oder einer Folie aus metallischem Lithium vorgesehen.

Sowohl der Stromableiter 102 als auch die aus metallischem Lithium ausgeführte Anode 110 ist jeweils mittels eines Kontaktierungsmittels 17 reversibel elektrisch kontaktiert.

Bei der in Figur 5b dargestellten alternativen Ausführungsform umfasst die zu untersuchende Komponente 100 bspw. einen insbesondere schichtförmigen Separator 120, der eine Schicht eines Separatormaterials umfasst. Dieser ist bspw. jeweils auf seiner Großfläche mit einer Kathode 112 beschichtet, welche ein mit dem Separator 120 in physischem Kontakt stehendes Elektrodenaktivmaterial 106 sowie einen Stromableiter 102 umfasst. Beide Stromableiter 102 sind ihrerseits jeweils mittels eines Kontaktierungsmittels 17 reversibel elektrisch kontaktiert.

In Figur 5c ist eine weitere alternative Ausführungsform dargestellt, bei der die zu untersuchende Komponente 100 bspw. einen insbesondere schichtförmigen Separator 120, der zwei Schichten eines Separatormaterials umfasst. Dieser ist bspw. jeweils auf seiner Großfläche mit einer Kathode 112 beschichtet, welche ein mit den beiden Schichten des Separators 120 in physischem Kontakt stehendes Elektrodenaktivmaterial 106 sowie einen Stromableiter 102 umfasst. Beide Stromableiter 102 sind ihrerseits jeweils ebenfalls mittels eines Kontaktierungsmittels 17 reversibel elektrisch kontaktiert.

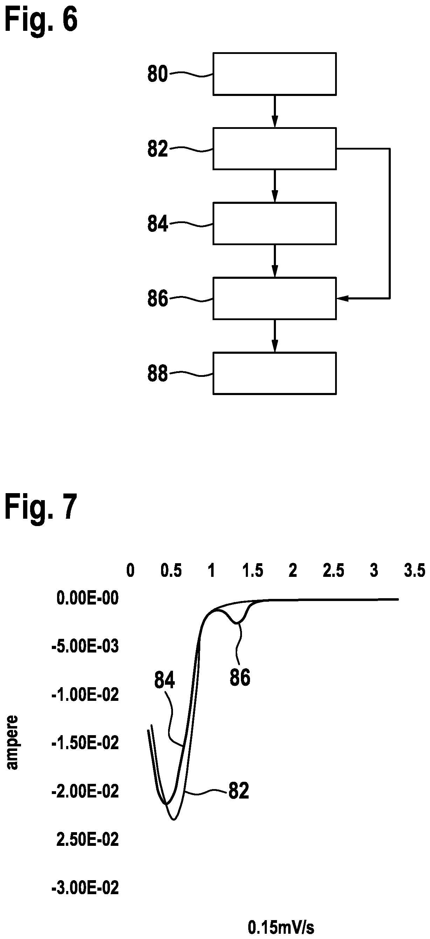

In Figur 6 ist schematisch ein Verfahren zum Betrieb einer Vorrichtung gemäß den in den Figuren 1 bis 5 ausgeführten Ausführungsformen graphisch verdeutlicht.

In einem ersten Schritt 80 wird beispielsweise eine zu untersuchende Komponente 100 für Batteriezellen in der Aufnahmevorrichtung 14 der Vorrichtung 10, 20, 30, 40 vorgelegt. In einem zweiten Schritt 82 wird ein metallischer Kontakt 16 in einen physischen, elektrisch leitenden Kontakt mit einer Oberfläche der Komponente 100 gebracht. Gleichzeitig oder in einem nachfolgenden Schritt 84 wird beispielsweise ein Stromableiter 102 der Komponente 100 mittels eines Kontaktierungsmittels 17 elektrisch kontaktiert, sofern die Komponente 100 einen Stromableiter 102 einer darin enthaltenen Elektrode 110, 112 aufweist. Ist dies nicht der Fall, so werden im zweiten Schritt 82 beispielsweise zwei metallische Kontakte 16 in elektrisch leitenden Kontakt mit der Komponente 100 gebracht. Ggf. ist weiterhin eine geeignete Temperierung vorgesehen.

In einem dritten Schritt 86 wird mittels der Spannungsquelle 18 eine Spannung an die Komponente 100 zur elektrochemischen Untersuchung derselben angelegt. Dabei werden beispielsweise Lösungsmittelreste, die während einer Herstellung der Komponente 100 im Material derselben verblieben sind, elektrochemisch oxidiert bzw. reduziert. Nach Fertigstellung der elektrochemischen Untersuchung der Komponente 100 wird diese in einem abschließenden Schritt 88 aus der Aufnahmevorrichtung 14 entfernt.

Die Bestimmung der Menge von insbesondere flüssigen Bestandteilen in einer Komponente für Batteriezellen gemäß drittem Schritt 86 des vorbeschriebenen Verfahrens erfolgt bspw., indem an eine Vorrichtung zur Bestimmung der Menge von insbesondere flüssigen Bestandteilen in Komponenten für Batteriezellen gemäß der fünften Ausführungsform eine sich zeitlich ändernde, insbesondere sich linear ändernde Spannung angelegt wird. Zu Beginn der Bestimmung liegt dabei bspw. an der Anode 110 einer Komponente 100 gemäß der in Figur 5a dargestellten Ausführungsform ein Potential von 0V versus Li an.

Die Komponente 100 in Form eines Elektrodenstapels bzw. einer elektrochemischen Zelle weist daher als Zellspannung das Potential der Kathode auf. Zur definierten Reduktion eines möglicherweise in der Komponente 100 enthaltenen Bestandteils, bspw. eines Lösungsmittels, wird das Potential an der Kathode 112 bspw. in Höhe von anfangs -3.25V vs. Lithium im Fall einer Vollzelle mittels der Spannungsquelle 18 verringert. Bei einem Potential von <1.8V versus Li wird bspw. Cyclohexanon reduziert und ein dazugehöriger Strom wird erfasst. Dies kann mit einem Potentialsweep, also einer sich zeitlich linear ändernden, angelegten Spannung an die Komponente 100 in Höhe von bspw. 0,15mV/s erfolgen. Bei einem derartigen Potentialsweep wird bspw. ein Voltammogramm einer lösungsmittelhaltigen Kathode mit einer trockenen, lösungsmittelfreien Elektrode verglichen.

Dies ist beispielhaft in Figur 7 dargestellt. Figur 7 zeigt eine Auftragung der bestimmten Stromstärke über der an die Komponente 100 angelegten Spannung. Eine erste Messkurve 82 entspricht einem Voltammogramm einer Komponente 100, die keine insbesondere flüssigen Bestandteile wie bspw. Lösungsmittel aufweist. Eine zweite Messkurve 84 entspricht einem Voltammogramm einer Komponente 100, die Cyclohexanon als insbesondere flüssigen Bestandteil aufweist. Dabei ist erkennbar, dass die zweite Messkurve 84 aufgrund des enthaltenen Anteils an Cyclohexanon ein zusätzlich Messsignal 86 bzw. einen zusätzlichen Peak zeigt. Durch Differenzbildung der den Messkurven 82, 84 zugrundeliegenden Reduktionsströme kann direkt auf den Gehalt an Cyclohexanon in der Komponente 100 geschlossen werden.

Die Bestimmung des Gehalts eines insbesondere flüssigen Bestandteils in der Komponente 100 erfolgt bspw. aufgrund der Erkenntnis, dass der aus der Differenzbildung ermittelte, absolut gemessene Strom in Coulomb, der während einer Reduktion des zu bestimmenden Bestandteils auftritt, direkt proportional zur Menge des Bestandteils, bspw. Cyclohexanon, in der Komponente 100 und einer aktiven Fläche ist. Unter einer aktiven Fläche wird der Flächeninhalt diejenigen Oberflächenbereiche eines elektrischen Kontakts oder eines Kontaktierungsmittels verstanden, die während eines Betriebs der Vorrichtung 10, 20, 30, 40 stromdurchflossen sind. Durch eine entsprechende Kalibrierung wie bspw. eine entsprechende gravimetrische Vergleichsmessung kann ein für die Umrechnung dienender Proportionalitätsfaktor bestimmt werden, bspw. auch durch Umrechnung mittels des Faraday'schen Gesetztes.

Die erfindungsgemäße Vorrichtung bzw. das erfindungsgemäße Verfahren zum Betrieb derselben lässt sich in vorteilhafter Weise einsetzen zur elektrochemischen Bearbeitung von Komponenten für Batteriezellen, insbesondere von lithiumhaltigen Batteriezellen für Akkumulatoren oder in Brennstoffzellen. Diese wiederum finden Verwendung beispielsweise in mobilen Anwendungen wie Elektrofahrzeugen, Hybridfahrzeugen oder Plug-In-Hybridfahrzeugen sowie in Heimwerkeranwendungen als auch in portablen Einrichtungen zur Telekommunikation. Weiterhin können derartige Batteriezellen in stationären Energiespeichern beispielsweise zur Speicherung regenerativ erzeugter elektrischer Energie verwendet werden.

## Patentansprüche

1. Vorrichtung zur Bestimmung der Menge von insbesondere flüssigen Bestandteilen in Komponenten für Batteriezellen in Form einer Elektrode, eines Separators oder einer Kombination derselben, umfassend eine Aufnahmevorrichtung (14) zur Aufnahme einer untersuchenden Komponente (100) für Batteriezellen, **dadurch gekennzeichnet, dass** die Vorrichtung (10, 20, 30, 40, 50) mindestens zwei elektrische Kontakte (16) aufweist, die insbesondere reversibel mit der zu untersuchenden Komponente (100) für Batteriezellen in physischen Kontakt bringbar ausgeführt sind, dass ein Mittel (18) zum Anlegen einer Spannung an die elektrischen Kontakte (16) vorgesehen ist, dass weiterhin eine Vorrichtung (42) zur Bestimmung eines bei Anlegen der Spannung an die elektrischen Kontakte (16) fließenden elektrischen Stroms vorgesehen ist und dass ein Mittel (19) zur Korrelation des durch die Komponente (100) fließenden elektrischen Stroms mit einer Menge von insbesondere flüssigen Bestandteilen in der Komponente (100) vorgesehen ist.

2. Vorrichtung nach Anspruch 1, **dadurch gekennzeichnet, dass** für die Bestimmung der Menge von insbesondere flüssigen Bestandteilen in einer Komponente (100) für Batteriezellen in Form eines Schichtverbundes einer Elektrode (110, 112) mit einem Separator (120) ein erster und ein zweiter elektrischer Kontakt (16) vorgesehen ist, wobei der zweite elektrische Kontakt (16) als ein Kontaktierungsmittel (17) zur reversiblen elektrischen Kontaktierung der Elektrode (110, 112) ausgebildet ist, derart, dass das Anlegen der Spannung zwischen dem ersten elektrischen Kontakt (16) und dem Kontaktierungsmittel (17) erfolgt.

3. Vorrichtung nach Anspruch 1, **dadurch gekennzeichnet, dass** bei einer Komponente (100) für Batteriezellen in Form eines Schichtverbundes zweier Elektroden (110, 112) mit einem Separator (120) ein erster und ein zweiter elektrischer Kontakt (16) als Kontaktierungsmittel (17) ausgebildet sind, die derart ausgeführt sind, dass diese reversibel mit den Elektroden (110, 112) in elektrischen Kontakt bringbar ausgestaltet sind.

4. Vorrichtung nach einem der vorhergehenden Ansprüche, **dadurch gekennzeichnet, dass** weiterhin ein Steuerungsmittel (19) zum Anlegen einer elektrischen Spannung an die Komponente (100) für Batteriezellen vorgesehen ist, die einen Speicher oder ein gespeichertes Kennfeld zur Hinterlegung einer Spannung oder eines Spannungsverlaufs umfasst, insbesondere die ein Kennfeld einer Spannung oder eines Spannungsverlaufs in Abhängigkeit eines in der Komponente (100) zu bestimmenden Bestandteils aufweist.

5. Vorrichtung nach einem der vorhergehenden Ansprüche, **dadurch gekennzeichnet, dass** das zu bestimmende Lösungsmittel Wasser oder ein organisches Lösungsmittel, insbesondere Cyclohexanon ist.

6. Vorrichtung nach einem der vorhergehenden Ansprüche, **dadurch gekennzeichnet, dass** mindestens ein elektrischer Kontakt (16) eine Heizvorrichtung (22), insbesondere eine elektrische Widerstandsheizung, umfasst.

7. Vorrichtung nach einem der vorhergehenden Ansprüche, **dadurch gekennzeichnet, dass** ein Flächeninhalt der Fläche des elektrischen Kontakts (16), die mit der zu untersuchenden Komponente (100) in physischen Kontakt kommt, ungleich dem Flächeninhalt einer Großfläche der zu untersuchenden Komponente (100) ist.

8. Verfahren zum Betrieb einer Vorrichtung gemäß einem der vorhergehenden Ansprüche, **dadurch gekennzeichnet, dass** eine Komponente (100) für Batteriezellen von einer Aufnahmevorrichtung (14) der Vorrichtung (10, 20, 30, 40, 50) in einem ersten Schritt (80) aufgenommen wird, in einem zweiten Schritt (82) mindestens zwei elektrische Kontakte (16, 17) mit der Komponente (100) für Batteriezellen in physischen Kontakt gebracht werden, in einem dritten Schritt (84) an die Komponente (100) für Batteriezellen eine elektrische Spannung mittels der mindestens zwei elektrischen Kontakte (16, 17) angelegt wird und der sich aufgrund der angelegten Spannung einstellende elektrische Strom erfasst und mit der Menge eines Bestandteils in der Komponente (100) korreliert wird.

9. Verfahren nach Anspruch 8, **dadurch gekennzeichnet, dass** der Ladungsmenge des sich einstellenden Stroms oder einem Integral der Stromstärke über der Zeit eine Menge eines oder mehrerer insbesondere flüssiger Bestandteile in der Komponente (100) für Batteriezellen zugeordnet wird.

10. Verfahren nach Anspruch 9, dass bei der Zuordnung weiterhin ein Flächeninhalt der Fläche des elektrischen Kontakts (16), die mit der zu untersuchenden Komponente (100) in physischen Kontakt kommt, mit berücksichtigt wird.

11. Verfahren nach einem der Ansprüche 8 bis 10, **dadurch gekennzeichnet, dass** zur Bestimmung der Menge von organischen Bestandteilen, insbesondere von Cyclohexanon, in Komponenten für Batteriezellen, als Komponente (100) für Batteriezellen ein Schichtverbund einer metallisches Lithium aufweisenden Elektrode (110) mit mindestens einem Separator (120) und mindestens einer weiteren Elektrode (112) verwendet wird.

12. Verfahren nach einem der Ansprüche 8 bis 10, **dadurch gekennzeichnet, dass** zur Bestimmung der Menge von organischen Bestandteilen, insbesondere von Cyclohexanon, in Komponenten für Batteriezellen, als Komponente (100) für Batteriezellen ein Schichtverbund zweier Elektroden (112) gleichen Materials mit mindestens einem Separator (120) verwendet wird.

13. Verfahren nach einem der Ansprüche 8 bis 12, **dadurch gekennzeichnet, dass** die angelegte Spannung einer elektrochemischen Zersetzungsspannung des zu bestimmenden Bestandteils entspricht.

14. Verwendung einer Vorrichtung nach einem der Ansprüche 1 bis 7 sowie eines Verfahrens nach einem der Ansprüche 8 bis 13 zur Herstellung von Batteriezellen, insbesondere von wiederaufladbaren, lithiumhaltigen Batteriezellen für Batterien für mobile Anwendungen wie Elektrofahrzeuge, Hybridfahrzeuge oder Plug-In-Hybridfahrzeuge oder für portable Anwendungen wie Heimwerkergeräte oder Einrichtungen zur mobilen Telekommunikation sowie für Batterien in stationären Anwendungen, insbesondere zur Speicherung regenerativ erzeugter elektrischer Energie.
